# EUROPÄISCHE PATENTANMELDUNG

(11) **EP 1 578 182 A2**
(43) Veröffentlichungstag der Anmeldung: **21.09.2005**
(21) Anmeldenummer: 05002638.4
(22) Anmeldetag: 09.02.2005
(51) Int. Cl.: H05K 5/02

(54) **Vorrichtung zur Befestigung einer portablen elktronischen Einheit**

(30) Priorität: 20.03.2004 DE 102004013875
(71) Anmelder: Z/I Imaging GmbH, 73431 Aalen (DE)
(72) Erfinder: Krause, Helmut, Dr., 70199 Stuttgart (DE); Kolsch, Ingo Dr., 71101 Schönaich (DE); Preis, Karl-Heinz, 89522 Heidenheim (DE); Litz, Alexander, 89551 Königsbronn (DE)
(74) Vertreter: Lorenz, Werner

(57) **Zusammenfassung**

Die Erfindung betrifft eine Vorrichtung zur Befestigung einer portablen elektronischen Einheit an einem Adapter (2), welcher elektronisch und/oder mechanisch mit einer Konstruktionseinheit, insbesondere einem Flugzeug, verbunden ist. Der Adapter (2) ist mit einer Verriegelungseinrichtung versehen, wobei die Verriegelungseinrichtung (3) ein über eine Welle (4) gelagertes Bedienelement (5) aufweist, wobei die Welle (4) mit einer Exzentereinrichtung (12) versehen ist und wobei die Exzentereinrichtung (12) die in den Adapter (2) eingesetzte portable Einrichtung (1) durch eine Betätigung des Bedienelementes (5) über einen Totpunkt der Exzentereinrichtung (15) hinaus in eine vibrationsfeste Verschlussstellung schiebt.

## Beschreibung

Die Erfindung betrifft eine Vorrichtung zur Befestigung einer portablen elektronischen Einheit an einem Adapter, welcher elektrisch und/oder mechanisch mit einer Konstruktionseinheit verbunden ist.

Die Erfindung betrifft auch eine Vorrichtung zur Befestigung eines portablen Speichereinrichtung in einem Flugzeug.

Aus dem allgemeinen Stand der Technik sind verschiedene portable elektronische Einheiten bekannt, die zur zweckmäßigen Nutzung mit einer Konstruktionseinheit verbunden werden. Bei den portablen elektronischen Einheiten kann es sich beispielsweise um portable Computersysteme oder einzelne Systembausteine, wie z.B. ein tragbares Speichermedium handeln. Die tragbaren portablen Einheiten können beispielsweise auch als elektronische Bausteine, wie z.B. Instrumente, medizintechnische Geräte und dergleichen ausgebildet sein.

Die Konstruktionseinheit kann beispielsweise als Land-, See- oder Luftfahrzeuge ausgebildet sein.

Insofern es sich bei der portablen elektronischen Einheit um ein Laptop handelt sind Adapter zur Verbindung mit einem Landfahrzeug bekannt. Die Adapter ermöglichen dabei eine Fixierung und/oder ein schnelles Auswechseln des Laptops.

Von Nachteil bei den bekannten Adaptern ist dabei, dass deren Handhabung umständlich und aufwändig ist. Darüber hinaus ist die Verriegelungseinrichtung nicht ausreichend gegen ein versehentliches Öffnen bei Vibrationen und Stößen geschützt.

Aus dem allgemeinen Stand der Technik sind auch sogenannte Festplattenspeicher bzw. Flugdatenspeicher bekannt, auf denen während eines Bildfluges eines Flugzeuges die von einer digitalen Kamera anfallenden Daten abgelegt werden. Bei diesen Daten kann es sich z.B. um Bilddaten, ergänzende Daten zu den Bildern, wie z.B. Missionsdaten, Systeminformationen oder allgemeine Informationen für das post processing handeln. Der Flugdatenspeicher ist im allgemeinen als Massenspeicher zur "digital mapping camera" ausgelegt.

Elektrisch und mechanisch ist jeder Flugdatenspeicher eine eigenständige Einheit, die über einen BilddatenAnschluss mit der digitalen Kamera verbunden ist.

Im Flugzeug wird jede Speichereinrichtung mechanisch befestigt und in einem weiteren Arbeitsgang elektrisch mit allen notwendigen Kabeln verbunden. Der Flugdaten-speicher speichert die Bilddaten während des Fluges.

Nach der Landung wird der Flugdatenspeicher entnommen und die Bilddaten auf einen erdgebundenen Massenspeicher kopiert. Da der Platz im Flugzeug sehr beengt ist, und der Flugdatenspeicher abhängig vom Flugzeugtyp und der Einbausituation der Kamera, an unterschiedlichen Plätzen eingebaut werden muss, sind besondere Ansprüche an die Vorrichtung zur Befestigung des Flugdaterispeichers zu stellen. Der Austausch des Flugdatenspeichers sollte komfortabel und möglichst ohne zusätzliches Werkzeug möglich sein.

Die aus dem allgemeinen Stand der Technik bekannten Vorrichtungen zur Befestigung eines Flugdatenspeichers sind aufwändig in der Handhabung und benötigen in der Regel zusätzliches Werkzeug, um die portable Einheit fest und zuverlässig mit dem Flugzeug zu verbinden bzw. zu verschrauben. Darüber hinaus ist das Verbinden der Kontaktelemente des Flugdatenspeichers mit entsprechenden weiterführenden Kabeln mühsam und aufgrund der beengten Platzverhältnisse im Flugzeug oftmals sehr diffizil. Dies gilt insbesondere bei hohen Datenübertragungsraten. Ein falscher Anschluss von Kabeln kann dabei schnell zu einer Fehlfunktion führen. Besonders bedeutsam ist, dass die portable Einheit stabil mit dem Flugzeug verbunden ist, da ansonsten aufgrund der Flugbewegungen des Flugzeugs die Gefahr eines versehentlichen Lösens des Flugdatenspeichers bzw. ein Lösen der Kabelverbindungen zu befürchten ist.

Der vorliegenden Erfindung liegt daher die Aufgabe zugrunde, eine Vorrichtung zur Befestigung einer portablen elektronischen Einheit bzw. einer Speichereinrichtung in einem Flugzeug zu schaffen, die die vorgenannten Nachteile des Standes der Technik löst, insbesondere einfach bedienbar, zuverlässig und vibrations- und stoßsicher ist.

Erfindungsgemäß wird diese Aufgabe durch den kennzeichnenden Teil von Anspruch 1 gelöst.

Diese Aufgabe wird erfindungsgemäß auch durch den kennzeichnenden Teil von Anspruch 23 gelöst.

Durch die erfindungsgemäße Lösung gemäß Anspruch 1 ist es möglich, die portable Einheit in einfacher Weise in eine Verschlussstellung zu schieben und dort derart zu fixieren, dass ein selbständiges Lösen der Vorrichtung ausgeschlossen ist. Das Einschieben und Fixieren der portablen Einrichtung in dem Adapter ist mit der erfindungsgemäßen Lösung mittels einer Ein-Hand-Bedienung möglich. Zum Einschieben und Verriegeln der portablen Einheit muss diese in einem ersten Schritt in einer vorgesehenen Position in den Adapter eingesetzt werden. Anschließend wird durch eine Bedienung des Bedienelementes die mit der Exzentereinrichtung versehene Welle gedreht, sodass die Exzentereinrichtung die portable Einheit kontaktiert und im folgenden in eine Verschlussstellung schiebt. Dabei ist vorgesehen, dass die Exzentereinrichtung die in dem Adapter eingesetzte portable Einheit über einen Totpunkt des Exzenters hinaus in die Verschlussstellung schiebt. Dadurch ist sichergestellt, dass sich die portable Einheit nicht mehr selbständig in die entgegengesetzte Richtung bewegt.

Eine Bewegung der portablen Einheit entgegen der Einschubrichtung führt aufgrund der Tatsache, dass der Exzenter über den Totpunkt bewegt worden ist, dazu, dass sich die Verriegelungseinrichtung noch fester verschließt.

Von Vorteil ist, wenn der Adapter und die portable Einheit jeweils Kulissenelemente aufweisen, die zum Einnehmen der Verschlussstellung zueinander verschiebbar und in Verschlussstellung miteinander verklemmbar bzw. verkeilbar sind.

Vorzugsweise können die Kulissenelemente dabei in Form von aufeinander ausgerichteten Vorsprüngen ausgebildet sein, die sich durch die Einschubbewegung ineinander bzw. zueinander verschieben lassen. Die Kulissenelemente können dabei nach dem Prinzip einer Nut-Feder-Verbindung miteinander verbunden werden, wobei durch die Einschubbewegung bzw. die Relativbewegung der portablen Einheit zu dem Adapter das als Feder ausgebildete Kulissenelement in das als Nut ausgebildete Kulissenelement einfährt. Von Vorteil ist es, wenn der Adapter seitliche Führungen aufweist, die sich von einer Bodenfläche des Adapters nach oben erstrecken und wenigstens einen unteren Bereich der in dem Adapter eingesetzten portablen Einheit seitlich umfassen.

Durch die seitlichen Führungen erhält die portable Einheit eine seitliche Fixierung. Vorgesehen sein kann dabei auch, dass die adapterseitigen Kulissenelemente an der Innenseite der seitlichen Führungen angeordnet sind. Durch eine Anordnung der Kulissenelemente der portablen Einheit an deren Außenseite in einem Bereich, der von den seitlichen Führungen des Adapters umfasst wird, ergibt sich eine stabile Führung für die portable Einheit. Durch die Betätigung des Bedienelementes wird die portable Einheit mittels der seitlichen Führungen sowie der aufeinander gerichteten Kulissehelemente stabil und sicher in die Verriegelungsstellung geschoben.

In einer konstruktiven Ausgestaltung der Erfindung kann vorgesehen sein, dass die Exzentereinrichtung zwei Exzenterglieder bzw. Druckstücke aufweist, die jeweils im Bereich eines Endes der Welle angeordnet sind. Dabei kann jedem Exzenterglied eine horizontale und eine vertikale Kontaktfläche der portablen Einheit zugeordnet sein. Vorzugsweise sind die Exzenterglieder dabei als exzentrisch auf der Welle angeordnete Kurvenringe ausgebildet, die jeweils zwei radial überstehende Auskragungen aufweisen.

Wie sich in numerischen Simulationen und Versuchen herausgestellt hat, lässt sich die Drehbewegung der Welle in einfacher Weise in eine lineare Bewegung der portablen Einheit übertragen, wenn an jedem Ende der Welle ein Exzenterglied angeordnet ist.

Selbstverständlich kann die Exzentereinrichtung auch weniger oder mehr als zwei Exzenterglieder aufweisen. Vorgesehen sein kann dabei beispielsweise lediglich ein Exzenterglied, welches in der Mitte der Welle angeordnet ist. Im Unterschied zu der Anordnung von zwei Exzentergliedern jeweils am Wellenende muss bei der Anordnung eines mittigen Exzentergliedes eine identische Montage bzw. ein gleiches Ausrichten der Exzenterglieder (damit sich die Exzenterglieder nicht verklemmen bzw. ein einseitiges Tragen entsteht) nicht berücksichtigt werden.

Dadurch, dass die Exzenterglieder zwei radial überstehende Auskragungen aufweisen, lässt sich ein vorteilhafter zweistufiger Bewegungsablauf auf die portable Einheit übertragen. Von Vorteil ist es dabei, wenn in der ersten Stufe der Drehbewegung der Welle die jeweils in Drehrichtung der Welle vorne liegenden Auskragungen der Exzenterglieder die jeweils zugeordneten vertikalen Kontaktflächen der portablen Einheit kontaktieren und die portable Einheit in die Verschlussstellung schieben. Die vertikalen Kontaktflächen der portablen Einheit eignen sich in besonders einfacher Weise dafür, die über die Welle eingeleitete Drehbewegung der beiden Exzenterglieder in eine horizontale Bewegung der portablen Einheit umzusetzen, sodass diese in die vorgesehene Verschlussstellung geschoben werden kann. Nachdem die portable Einheit die Verschlussstellung erreicht hat, ist konstruktiv vorgesehen, dass nunmehr die jeweils in Drehrichtung der Welle hinten liegenden Auskragungen der Exzenterglieder die horizontalen Kontaktflächen der portablen Einheit kontaktieren und die portable Einheit derart anheben, dass die portable Einheit senkrecht zur Einschubrichtung verklemmt bzw. verspannt ist. Hierzu wirken die Kulissenelemente des Adapters sowie des Flugdatenspeichers und die Exzenterglieder entsprechend zusammen. Die horizontalen Kontaktflächen der portablen Einheit eignen sich dabei in besonders einfacher Weise dafür, die portable Einheit anzuheben bzw. in vertikaler Richtung zu verschieben.

Wie der Erfinder in nicht naheliegender Weise erkannt hat, lässt sich durch den zweistufigen Bewegungsablauf der durch die Exzenterglieder auf die portable Einheit übertragen wird, ein einfaches Einschieben der portablen Einheit in den Adapter erreichen. Anschließend wird die portable Einheit, ohne dass weitere Handgriffe getätigt werden müssen, verriegelt. Zur Bedienung der erfindungsgemäßen Vorrichtung ist lediglich die Betätigung des Bedienhebels notwendig, durch den die Welle und somit auch die Exzenterglieder gedreht werden. Zum Auslösen der beiden Stufen der Drehbewegung muss der Anwender lediglich den Bedienhebel von einer Ausgangsstellung zu einer Endstellung bewegen. Weitere Arbeitsschritte sind nicht notwendig. Durch die Mimik des Bedienhebels ergibt sich aus einer geringen Bedienkraft eine hohe Verriegelungskraft.

In einer Weiterbildung der Erfindung hat es sich als vorteilhaft herausgestellt, die keilförmig ausgebildeten Kulissenelemente zueinander derart anzuordnen, dass diese durch das Anheben der portablen Einheit miteinander verklemmen bzw. verkeilen. Die aufeinander gerichteten Anlageflächen der Kulissenelemente können dabei vorzugsweise keilförmig ausgebildet sein. Die keilförmigen Kulissenelemente sind dabei derart ausgestaltet bzw. angeordnet, dass diese nur bis zu einem gewissen Punkt angehoben werden können. Da die beiden Exzenterglieder die portable Einheit nach oben drücken, die Kulissenelemente des Adapters jedoch ab ei-nem vorgegebenen Endpunktes ein weiteres Anheben verhindern, wird die portable Einheit fest und unverrückbar zu dem Adapter fixiert. Zur Fixierung des Adapters wirken folglich die unbeweglich am Adapter bzw. am Flugdatenspeicher befestigten Kulissenelemente und der die Exzentereinrichtung bewegende Bedienhebel zusammen. Durch die Betätigung des Bedienhebels wird der gesamte Flugdatenspeicher und somit auch die damit fest verbundenen Kulissenelemente angehoben.

Vorgesehen ist dabei, dass die Exzenterglieder die portable Einheit an einem Ende anheben. Durch das Anheben der portablen Einheit lediglich an einem Ende wird diese in einer leicht schiefen Position gebracht, sodass die portable Einheit in Zusammenarbeit mit den Kulissenelementen in beide Hauptrichtungen fixiert wird.

Von Vorteil ist es, wenn die Welle auf wenigstens einem Federelement angeordnet ist, welches die Welle im wesentlichen vertikal in Richtung auf die horizontalen Kontaktflächen vorspannt. Besonders geeignet ist dabei eine Ausbildung der Federelemente als Tellerfeder. Eine Anordnung der Welle auf wenigstens einem vorgespannten Federelement erhöht die Sicherheit gegen Verschleiß und gegen Toleranzfehler. Durch die Vorspannung der Welle ist sichergestellt, dass die in Drehrichtung hinten liegenden Auskragungen der Exzenterglieder auch nach einem entsprechenden Verschleiß noch in der Lage sind, die zugeordneten horizontalen Kontaktflächen der portablen Einheit zu kontaktieren, um die portable Einheit anzuheben und somit zu verriegeln. Prinzipiell kann hierfür auch eine entsprechend elastische bzw. biegeweiche Welle eingesetzt werden. Allerdings weist eine derartige Welle im allgemeinen in horizontaler und vertikaler Richtung die gleiche Steifigkeit auf. Der Erfinder hat jedoch festgestellt, dass eine hohe Steifigkeit der Welle in horizontaler Richtung und eine gewisse Elastizität der Welle in vertikaler Richtung (um Toleranzfehler und Verschleiß auszugleichen) besonders geeignet ist. Eine derartige unterschiedliche Steifigkeit der Welle in horizontaler und vertikaler Richtung lässt sich in vorteilhafter Weise erstens durch eine Ausgestaltung der Welle mit einem rechteckigen Querschnitt erreichen. Zweitens dadurch, dass sie in vertikaler Richtung auf der vorgenannten Feder ruht und seitlich geführt ist. Vorzugsweise ist die Feder dabei derart abgestimmt, dass diese erst ab einer gewissen Druckbelastung nachgibt. Die Druckbelastung, ab der die Feder nachgibt und sich folglich die Welle in Richtung auf die Feder bewegt, ist vorzugsweise derart gewählt, dass normale Schwingungen und Stöße nicht zu einer Bewegung der Feder führen. Die Welle ist somit gegenüber normalen Schwingungen nicht elastisch. Somit wird eine Eigenschwingung der portablen Einheit vermieden.

In der genannten Ausgestaltung, bei der die Welle auf vorgespannten Tellerfedern ruht, hat es sich als besonders geeignet herausgestellt, die Welle steif bzw. sehr steif auszubilden. In Analysen und Versuchen hat sich ebenfalls eine Ausgestaltung der Welle mit einem rechteckigen Querschnitt als vorteilhaft herausgestellt.

In einer konstruktiven Ausgestaltung der Erfindung kann ferner vorgesehen sein, dass der Adapter und die portable Einheit mit elektrischen Kupplungselementen versehen sind, die in Verschlussstellung miteinander kontaktieren. In vorteilhafter Weise ist es somit nicht mehr notwendig, die zum Anschließen der portablen Einheit notwendigen Kabel von Hand anzustecken.

Eine erfindungsgemäße Vorrichtung zur Befestigung einer portablen Speichereinrichtung in einem Flugzeug ergibt sich aus dem kennzeichnenden Teil von Anspruch 23 sowie hinsichtlich vorteilhafter Ausführungsformen aus den darauf bezogenen weiteren Ansprüchen. Eine besonders vorteilhafte Verriegelungseinrichtung für die in einem Flugzeug anzubringende Speichereinrichtung ergibt sich dabei aus Anspruch 1 sowie den darauf zurückbezogenen weiteren Ansprüchen.

Die sich aus Anspruch 23 ergebende erfindungsgemäße Lösung ermöglicht eine leicht zu bedienende, zuverlässige und stoßsichere Befestigung einer Speichereinrichtung in einem Flugzeug. Dabei wird ein zur Aufnahme der Speichereinrichtung geeigneter Adapter elektronisch und mechanisch mit dem Flugzeug verbunden. Zum Anbringen der Speichereinrichtung muss dieses nicht mehr wie bisher mechanisch an irgendeiner Stelle mit dem Flugzeug verschraubt werden, sondern kann in einfacher Weise in den vorgesehenen Adapter eingesetzt werden. Vorgesehen ist dabei auch, dass der Adapter und die Speichereinrichtung mit elektronischen Kupplungselementen versehen sind, die in Verschlussstellung miteinander kontaktieren. Ein Einsatz eines Adapters zur Befestigung einer Speichereinrichtung in einem Flugzeug ist aus dem Stand der Technik nicht bekannt, bringt jedoch, da gerade bei Flugzeugen eine zuverlässige und stoßfeste Verbindung wesentlich ist, enorme Vorteile gegenüber einer einfachen Verschraubung. Vorteilhaft ist dabei auch, dass das bisher mühsame und diffizile Anstecken bzw. Verbinden von Kabeln entfällt.

Von Vorteil ist es, wenn die Speichereinrichtung als Flugdatenspeicher ausgebildet ist, auf den während eines Bildfluges des Flugzeugs von einer digitalen Kamera anfallende Daten ablegbar sind.

Vorteilhafte Weiterbildungen und Ausgestaltungen der Erfindung ergeben sich aus den weiteren Unteransprüchen. Nachfolgend ist anhand der Zeichnung ein Ausführungsbeispiel der Erfindung prinzipmäßig dargestellt.

Es zeigt:
- Fig. 1: eine perspektivische Darstellung eines Adapters mit einer eingesetzten und verriegelten portablen Einheit;
- Fig. 2: die portable Einheit gemäß Fig. 1 in einer Einzeldarstellung;
- Fig. 3: eine perspektivische Darstellung der Verriegelungseinrichtung des Adapters;
- Fig. 4: eine schematische Darstellung der Welle der Verriegelungseinrichtung, die durch Federelemente in vertikaler Richtung vorgespannt ist;
- Fig. 5: ein prinzipieller Kennlinienvergleich zwischen einer elastischen bzw. biegeweichen Welle und einer steifen Welle, die gemäß Fig. 4 gelagert ist;
- Fig. 6: eine Darstellung eines Adapters mit einer eingesetzten portablen Einheit im unverriegelten Zustand;
- Fig. 7: eine Darstellung gemäß Fig. 6, wobei die portable Einheit bereits in Richtung auf die Verriegelungsstellung verschoben ist;
- Fig. 8: eine Darstellung.gemäß Fig. 6 und Fig. 7 wobei die portable Einheit die Verriegelungsstellung erreicht hat;
- Fig. 9a bis 9g: eine schematische Detaildarstellung eines Exzentergliedes sowie der Kontaktflächen der portablen Einheit während des Verriegelungsvorganges, und
- Fig. 10: eine Innenansicht des Flugdatenspeichers mit zwei Speichermedien die über eine Tragstruktur schwingungsgedämpft mit der Innenseite des Gehäuses des Flugdatenspeichers verbunden sind.

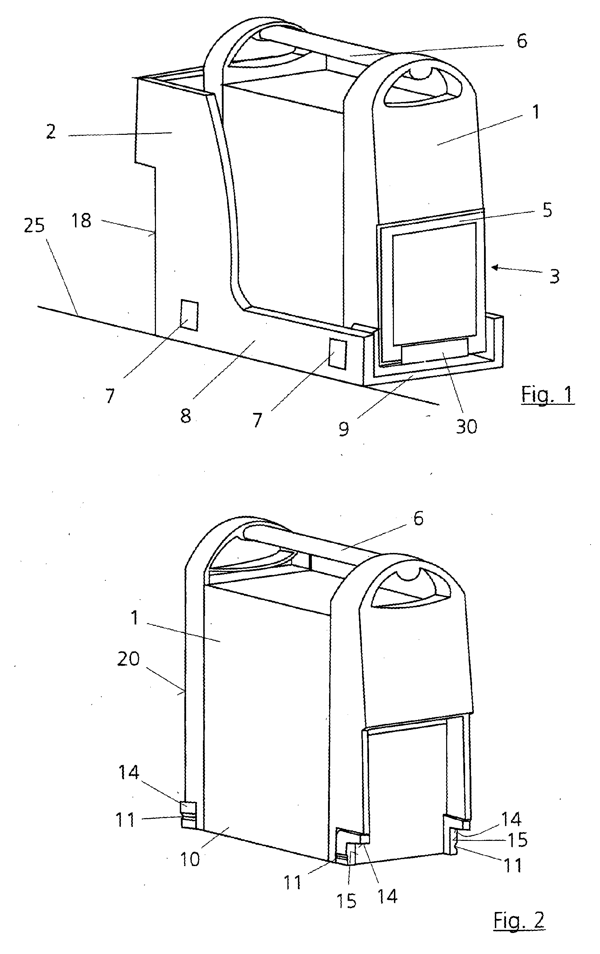

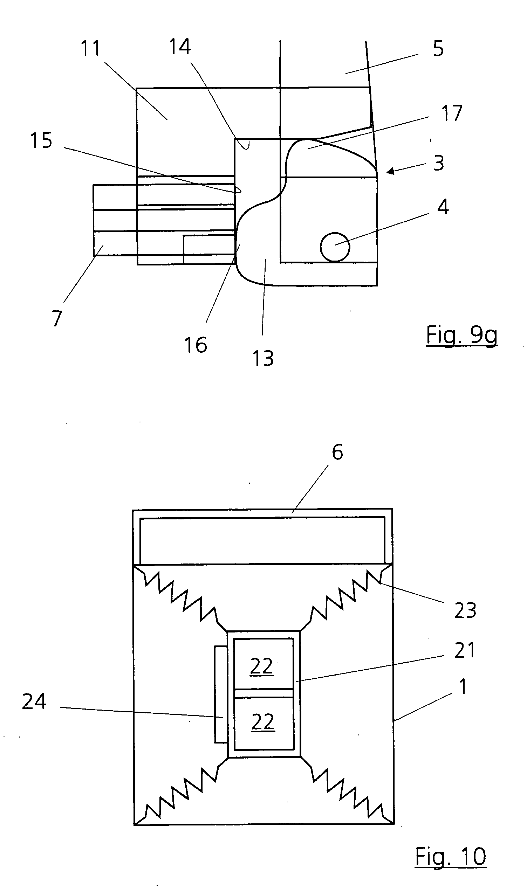

Fig. 1 zeigt die erfindungsgemäße Vorrichtung zur Befestigung einer portablen elektronischen Einheit 1 an einem Adapter 2. Der Adapter 2 ist dabei elektrisch und/oder mechanisch mit einer nicht näher dargestellten Konstruktionseinheit verbunden. Im Ausführungsbeispiel ist dabei vorgesehen, dass die portable elektronische Einheit als Speichereinrichtung in Form eines Festplattenspeichers bzw. als Flugdatenspeicher 1 ausgebildet ist. Der Flugdatenspeicher 1 dient dabei dazu, die während des Bildfluges eines Flugzeuges 25 von einer digitalen Kamera (nicht dargestellt) erfassten Daten abzulegen. Der Flugdatenspeicher 1 kann dabei beispielsweise mehrere Speichermedien (z.B. Festplatten) sowie gegebenenfalls weitere Systembestandteile (z.B. einen Controller) beinhalten (siehe Fig. 10).

Digitale Kameras zur Aufnahme derartiger Daten sind aus dem allgemeinen Stand der Technik hinlänglich bekannt, weshalb im Ausführungsbeispiel hierauf nicht näher eingegangen wird.

Prinzipiell eignet sich die erfindungsgemäße Vorrichtung zum Einsatz in den unterschiedlichsten Gebieten, bei denen eine zuverlässige Fixierung zwischen einer portablen Einheit 1 und einem Adapter 2 auch bei rauen Umgebungsbedingungen, wie z.B. im militärischen Einsatz oder allgemein bei Land-, See- oder Luftfahrzeugen erforderlich ist. Besonders bevorzugt lässt sich die erfindungsgemäße Vorrichtung einsetzen, wenn die portable Einheit als tragbares Computersystem oder als Teil eines Computersystemes, beispielsweise als Festplattenspeicher, ausgebildet ist, welcher beim Lesen oder Schreiben Stößen, Vibrationen oder Schwingungen ausgesetzt ist.

Insoweit die im Ausführungsbeispiel dargestellten Elemente aus dem allgemeinen Stand der Technik bereits bekannt sind, wird hierauf nachfolgend nicht näher eingegangen. Nachfolgend wird lediglich auf die für die Erfindung wesentlichen Merkmale näher eingegangen.

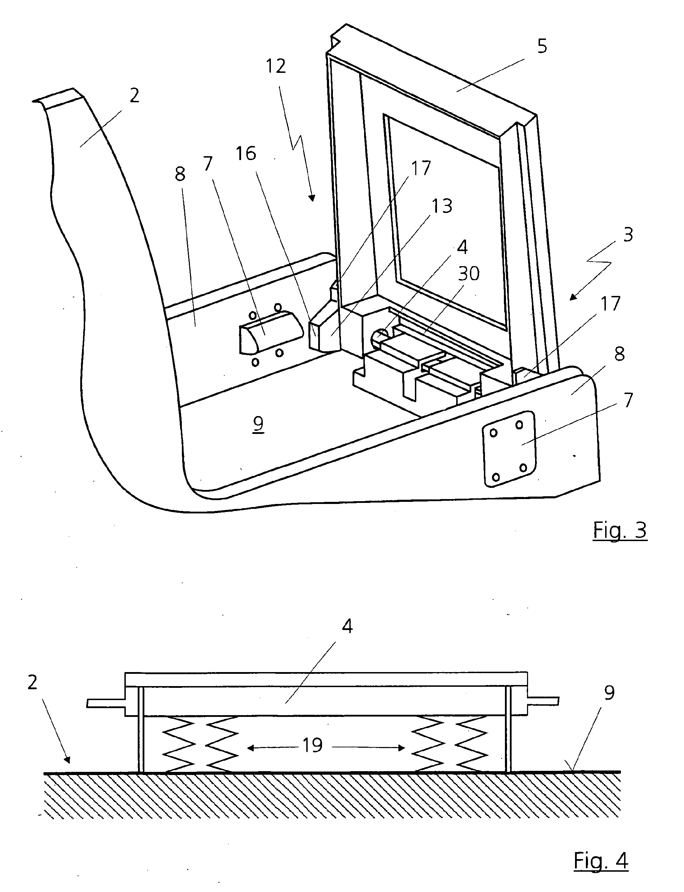

Wie aus Fig. 1 ersichtlich ist, ist der (außenseitig im wesentlichen als Gehäuse ausgebildete) Flugdatenspeicher 1 mittels einer Verriegelungseinrichtung 3 mit dem Adapter 2 verbunden bzw. verspannt. Die Verriegelungseinrichtung 3 weist dabei, wie aus Fig. 3 im Detail ersichtlich ist, ein über eine Achse bzw. eine Welle 4 gelagertes Bedienelement 5 auf. Das Bedienelement ist im Ausführungsbeispiel als manuell bedienbarer Bedienhebel 5 ausgebildet, der eine Drehung der Welle 4 mit einer ergonomischen Forderungen angemessenen Hebelkraft ermöglicht, die in eine vielfach größere Verspannkraft umgesetzt wird. In alternativen Ausführungsformen kann das Bedienelement 5 beispielsweise auch in Form eines Elektromotors oder dergleichen ausgebildet sein, der die Welle 4 in eine Drehbewegung versetzt. Zum einfachen Handhaben bzw. Einsetzen des Flugdatenspeichers 1 ist dieser an seiner Oberseite mit einem Griff 6 versehen. Insofern in dem Flugdatenspeicher 1 mehrere Speichermedien angeordnet sind, sind diese somit durch den Griff 6 bzw. das Gehäuse des Flugdatenspeichers 1 zu einer wechselbaren Einheit zusammengefasst.

Elektrisch und mechanisch ist der Flugdatenspeicher 1 als eigenständige Einheit ausgebildet, die über einen Bilddatenanschluss mit einer digitalen Kamera verbunden ist. Weiterhin ist ein Kontrolldaten-Eingang, ein Kontrolldaten-Ausgang und ein Versorgungsspannungs-Eingang, ein Versorgungsspannungs-Ausgang sowie ein serieller Anschluss für RAID-Konfiguration vorhanden.

Erfindungsgemäß kann vorgesehen sein, dass der Flugdatenspeicher ein Speichermedium oder mehrere Speichermedien und/oder weitere Systembestandteile aufweist bzw. beinhaltet. Im Ausführungsbeispiel ist in nicht dargestellter Weise vorgesehen, dass in dem Gehäuse des Flugdatenspeichers 1 mehrere Speichermedien angeordnet sind. Vorteilhaft ist dabei eine schwingungsgedämpfte Anordnung der Speichermedien in dem Gehäuse. Die Speichermedien in einer oder mehreren Tragstrukturen angeordnet sind, welche über eine Dämpfungseinrichtung, schwingungsgedämpft mit der Innenseite des Gehäuses des Flugdatenspeichers.

Wie aus Fig. 1 des weiteren ersichtlich ist, weist die Verriegelungseinrichtung 3 einen Lagerbock 30 auf, der wie aus Fig. 3 im Detail ersichtlich ist, zur Lagerung der Welle 4 dient.

Der Adapter 2 weist im Ausführungsbeispiel vier Kulissenelemente 7 auf, von denen in Fig. 2 zwei Kulissenelemente 7 in einer rückseitigen Darstellung ersichtlich sind. Der Adapter 2 weist dabei seitliche Führungen 8 auf, die sich von einer Bodenfläche 9 des Adapters 2 nach oben erstrecken und wenigstens einen unteren Bereich 10 des in den Adapter 2 eingesetzten Flugdatenspeichers 1 seitlich umfassen. Der Flugdatenspeicher 1 ist dabei im Detail in Fig. 2 dargestellt.

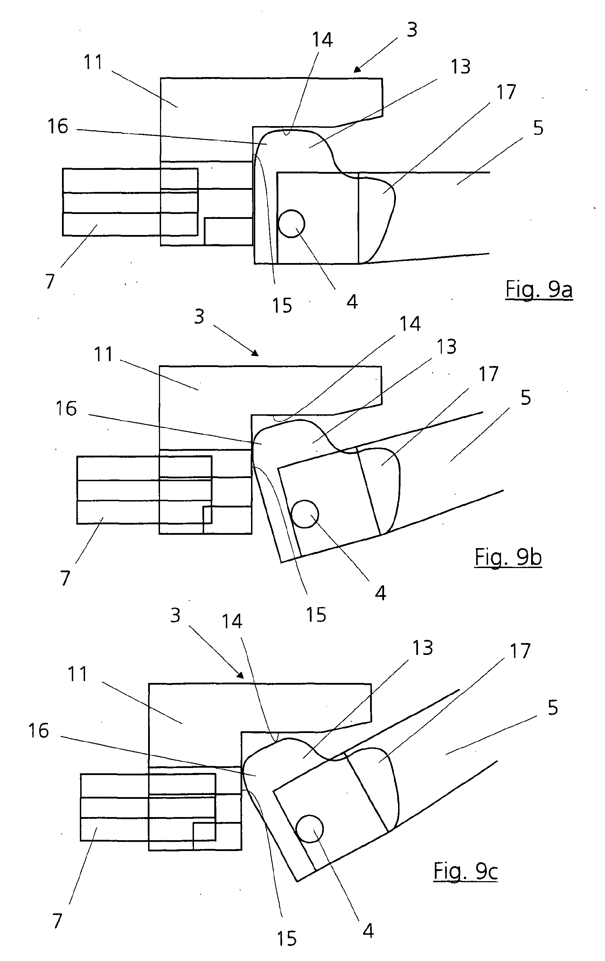

Analog zu den Kulissenelementen 7 des Adapters 2 weist der Flugdatenspeicher 1 ebenfalls vier Kulissenelemente 11 auf. Die Kulissenelemente 7, 11 sind dabei derart zueinander angeordnet, dass diese, wenn der Flugdatenspeicher 1 in die Verschlussstellung geschoben wird, zueinander verschoben werden. Wie sich aus einer Zusammenschau der Fig. 2 und der Fig. 3 sowie den Darstellungen gemäß Fig. 9a bis Fig. 9g ergibt, sind die Kulissenelemente 11 in Form einer Nut ausgebildet, in die die Kulissenelemente 7 einfahren können. Die Kulissenelemente 7 weisen dazu eine Feder auf bzw. sind in Form von Keilschienen ausgebildet. Die aufeinander gerichteten Anlageflächen der Kulissenelemente 7, 11 sind keilförmig ausgebildet.

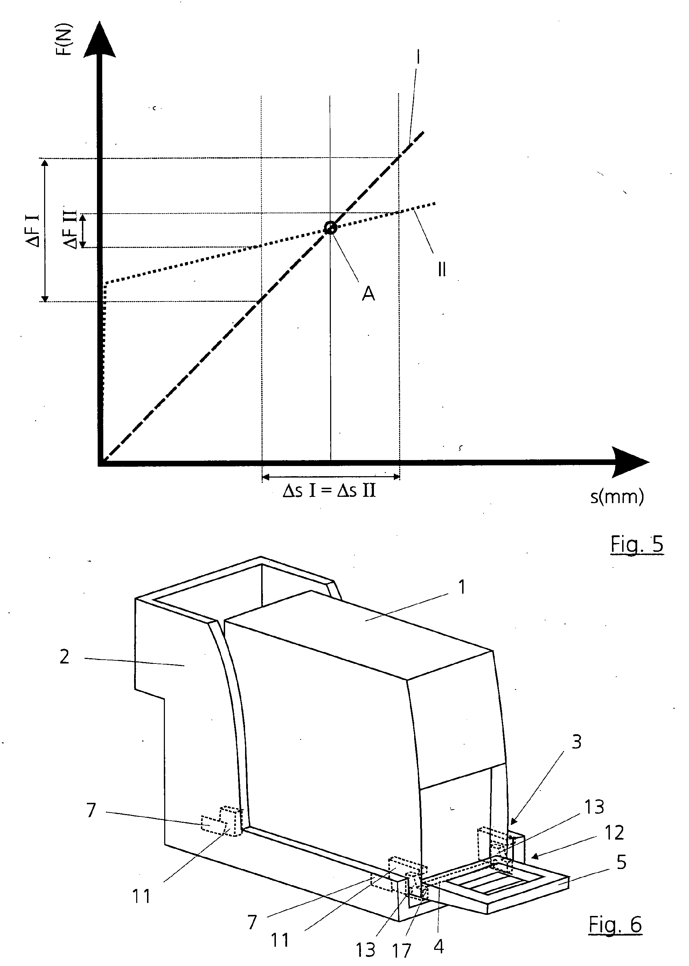

Die Kulissenelemente 7 des Adapters 2 sind an der Innenseite der seitlichen Führungen 8 angeordnet. Die Kulissenelemente 11 des Flugdatenspeichers 1 sind an der Außenseite des Flugdatenspeichers 1 im Bereich des unteren Endes 10 angeordnet. Wie aus Fig. 3 und den Figuren 6 bis 8 ersichtlich ist, ist die Welle 4 mit einer Exzentereinrichtung 12 versehen. Die Exzentereinrichtung 12 schiebt den in den Adapter 2 eingesetzten Flugdatenspeicher 1 durch eine Betätigung des Bedienhebels 5 über einen Totpunkt der Exzentereinrichtung 12 hinaus in eine Verschlussstellung. Der prinzipielle Verschlussvorgang ergibt sich dabei aus den Figuren 6 bis 8 und im Detail aus den Figuren 9a bis 9g.

Die Exzentereinrichtung 12 weist zwei Exzenterglieder 13 auf, die jeweils im Bereich eines Endes der Welle 4 angeordnet sind. Die Figuren 9a bis 9g zeigen dabei ein an einem Wellenende angeordnetes Exzenterglied 13. Jedem Exzenterglied 13 ist eine horizontale Kontaktfläche 14 und eine vertikale Kontaktfläche 15 des Flugdatenspeichers 1 zugeordnet. Die Exzenterglieder weisen jeweils zwei Auskragungen 16, 17 auf. Im Ausführungsbeispiel sind die Exzenterglieder 13 als exzentrisch auf der Welle 4 angeordnete Kurvenringe ausgebildet, die jeweils zwei radial überstehende Auskragungen 16, 17 aufweisen.

Die Auskragungen 16, 17 sind derart angeordnet bzw. ausgebildet, dass durch die Drehbewegung der Welle 4 ein zweistufiger Bewegungsablauf auf den Flugdatenspeicher 1 übertragbar ist.

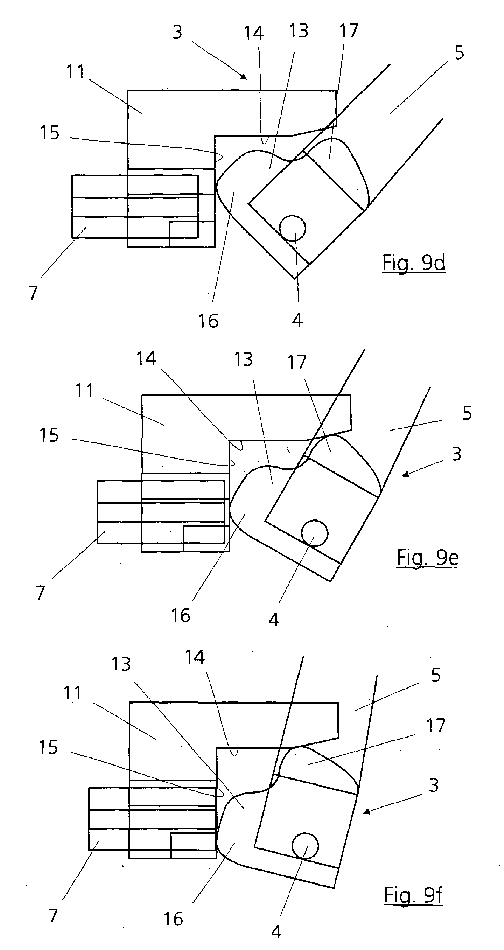

Die Fig. 9a bis 9g zeigen ein adapterseitig befestigtes Kulissenelement 7 (in einer Ausgestaltung als Keilleiste), ein an dem Flugdatenspeicher 1 befestigtes Kulissenelement 7, ein Exzenterglied 13 sowie den Bedienhebel 5 in sieben unterschiedlichen Stadien des Verriegelungsvorgangs. Fig. 9a zeigt den Bedienhebel und somit auch die Verriegelungseinrichtung 3 in einer Ausgangsstellung. Die Stellung des Bedienhebels 5 beträgt dabei 0°. Fig. 9b zeigt eine Stellung des Bedienhebels 5 in einem Winkel von 15° zur Ausgangslage. Fig. 9c zeigt eine Stellung des Bedienhebels 5 in einem Winkel von 30° zu der Ausgangslage. Fig. 9d zeigt eine Stellung des Hebels in einem Winkel von 45° zur Ausgangslage. Fig. 9e zeigt eine Stellung des Bedienhebels in einem Winkel von 60° zur Ausgangslage. Fig. 9f zeigt eine Stellung des Bedienhebels 5 in einem Winkel von 75° zur Ausgangslage. Fig. 9g zeigt den Verriegelungszustand, bei dem der Bedienhebel 5 eine Stellung von 90° zu der Ausgangslage einnimmt.

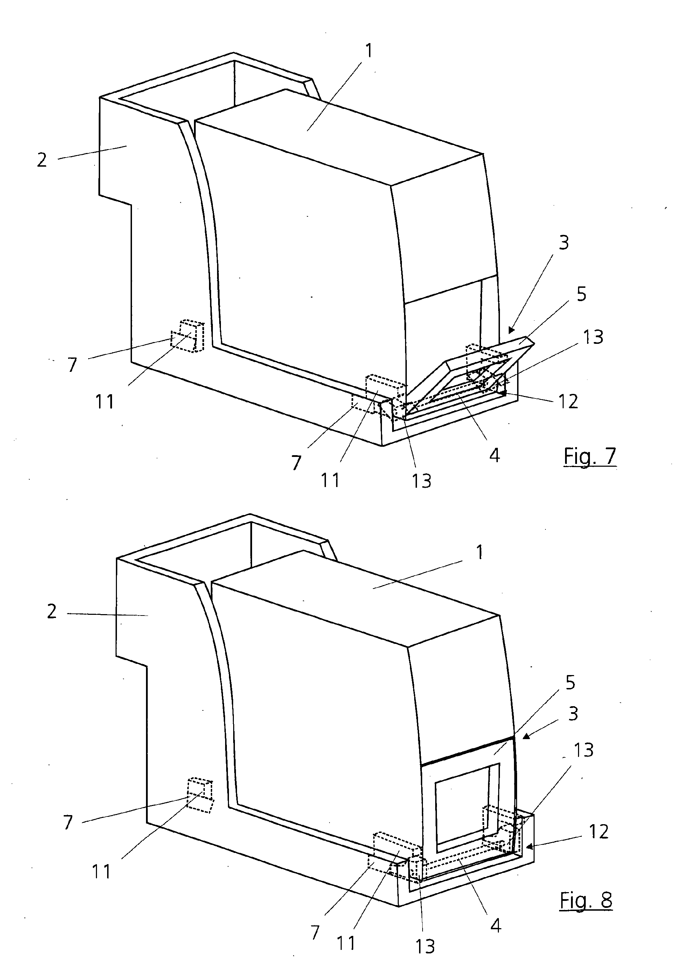

Wie sich aus Fig. 7 und den Figuren 9a bis 9g ergibt, kommt in der ersten Stufe der Drehbewegung die jeweils in Drehrichtung der Welle 4 vorne liegende Auskragung 16 eines Exzentergliedes 13 in Kontakt mit der jeweils zugeordneten vertikalen Kontaktfläche 15 des Flugdatenspeichers 1. Durch eine weitere Drehbewegung der Welle 4 drückt die Auskragung 16 immer stärker gegen die vertikale Kontaktfläche 15, sodass der Flugdatenspeicher 1 ab einem gewissen Druck ausweicht und somit in Richtung auf die Verschlussstellung verschoben wird. Die Auskragung 16 kontaktiert die vertikale Kontaktfläche 15 dabei so lange, bis sich der Flugdatenspeicher 1 in der Verschlussstellung befindet. Nach dem Erreichen der Verschlussstellung setzt die zweite Stufe der Drehbewegung ein, was bedeutet, dass die in Drehrichtung der Welle 4 hinten liegende Auskragung 17 des Exzentergliedes 13 nunmehr die horizontale Kontaktfläche 14 des Flugdatenspeichers 1 kontaktiert. Dadurch wird der Flugdatenspeicher 1 angehoben und in der Folge fixierend verklemmt (siehe Fig. 9g und Fig. 8). Die Welle 4 wird dabei mittels dem Bedienhebel 5 so weit gedreht, dass die hintere Auskragung 17 des Exzenterglieder 13 über ihren Totpunkt hinaus bewegt wird. Somit tritt eine Selbstsicherung ein.

Durch das Anheben des Flugdatenspeichers 1 werden die keilförmigen Kulissenelemente 11 des Flugdatenspeichers 1 ebenfalls angehoben und klemmend gegen die ebenfalls keilförmigen Kulissenelemente 7 des Adapters 2 gedrückt. Die Auskragungen 17 der Exzenterglieder 13 heben dabei den Flugdatenspeicher 1 soweit an, dass die Kulissenelemente 11 ohne Spiel an die Kulissenelemente 7 gepresst werden. Eine Bewegung des Flugdatenspeichers 1 vertikal zu dem Adapter 2 ist somit nicht mehr möglich. Die Verklemmung ist dabei derart ausgebildet, dass auch eine horizontale Bewegung des Flugdatenspeichers 1 zu dem Adapter 2 nicht mehr möglich ist. Unterstützt wird dies dadurch, dass die Kulissenelemente 7, 11 keilförmig ausgebildet sind und der Flugdatenspeicher 1 durch das Anheben an nur einem seiner Enden schief zu dem Adapter 2 verkeilt wird. Dadurch entsteht eine schiefe Ebene, aus der eine vorteilhafte Verkeilung der Kulissenelemente 7, 11 resultiert.

In nicht näher dargestellter Weise ist vorgesehen, dass der Adapter 2 an einer von der Verriegelungseinrichtung 3 abgewandten Rückseite 18 mit einer Auswurffeder (nicht dargestellt) versehen ist. Bei einem Öffnen der Verriegelungseinrichtung 3 soll die Auswurffeder eine Bewegung des Flugdatenspeichers 1 entgegen der Einschubrichtung unterstützen, sodass der Flugdatenspeicher 1 in einfacher Weise aus dem Adapter 2 entnommen werden kann.

Im Ausführungsbeispiel ist (im Detail nicht dargestellt) vorgesehen, dass die vorderen Auskragungen 16 in der Verschlussstellung nicht mehr an den vertikalen Kontaktflächen 15 anliegen. Die Verklemmung bzw. die Fixierung des Flugdatenspeichers 1 zu dem Adapter 2 ergibt sich somit ausschließlich durch die Kulissenelemente 7, 11 bzw. die hinteren Auskragungen 17 und die horizontale Kontaktflächen 14. Eine Kontaktierung der vorderen Auskragungen 16 mit den vertikalen Kontaktflächen 15 könnte unter Umständen im Zusammenhang mit der Auswurffeder eine Eigendynamik erzeugen, die möglichst verhindert werden soll.

In einer nicht dargestellten Ausgestaltung der Erfindung kann vorgesehen sein, dass die Welle 4 als elastische bzw. biegeweiche Welle ausgebildet ist.

Im Ausführungsbeispiel ist gemäß Fig. 4 vorgesehen, dass die Welle 4 auf wenigstens einem Federelement 19 angeordnet ist, welches die Welle 4 im wesentlichen vertikal in Richtung auf die horizontalen Kontaktflächen 14 vorspannt. Im Ausführungsbeispiel sind die Federelemente 19 in Form von zwei Tellerfederpaketen ausgebildet. Die Welle 4 ruht dabei auf den beiden Tellerfederpaketen 19 bzw. liegt auf diesen auf. Somit kann die Welle 4 im Ausführungsbeispiel als steife Welle ausgebildet sein. Dies ermöglicht es, die Welle mit unterschiedlichen Steifigkeiten in horizontaler und vertikaler Richtung auszubilden. Aufgrund der vorgespannten Tellerfederpakete 19 ist die Welle 14 in vertikaler Richtung quasi degressiv ausgebildet, woraus eine Erhöhung der Sicherheit gegen Verschleiß und Toleranzfehler resultiert, weil relativ große Wegänderungen zu relativ geringen Kraftänderungen führen.

In horizontaler Richtung ist eine hohe Steifigkeit der Welle 4 vorteilhaft, um ein Ausweichen der Welle 4 während des Verschlussvorganges weitgehend zu vermeiden. In vertikaler Richtung ist hingegen eine Elastizität zum Verspannen der Welle 4 vorteilhaft, sofern die Elastizität aus der Welle zum Verspannen eingesetzt wird und nicht die Konstruktionsvariante "steife Welle auf elastischer Feder" zur Anwendung kommt.

Fig. 5 zeigt einen Unterschied zwischen den Kennlinien einer im Ausführungsbeispiel nicht dargestellten biegeweichen Welle und der dargestellten steifen Welle 4, die über Tellerfederpakete 19 gelagert ist. Die Kennlinie I stellt dabei die Kennlinie der biegeweichen Welle dar. Die Kennlinie II stellt die Kennlinie der steifen Welle 4, welche auf Tellerfederpaketen 19 gelagert ist, dar. Wie in Fig. 5 schematisch dargestellt ist, variiert die (Spann-) Kraft der steifen Welle 4 bei gleicher Weglänge um den Arbeitspunkt A wesentlich geringer (ΔSI = ΔSII, jedoch ΔFI > ΔFII). Das heißt, ein möglicher Spannkraftverlust durch Verschleiß oder Toleranz fällt bei der steifen Welle 4 (Kennlinie II) wesentlich geringer aus.

Die Tellerfederpakete 19 sind im Ausführungsbeispiel derart ausgebildet, dass im normalen Flugbetrieb auftretende Schwingungen und Vibrationen zu keiner bedeutsamen Bewegung der Welle 4 führen. Erst ab einer definierten Kraft geben die Tellerfederpakete 19, wie sich aus Fig. 5 ergibt, entsprechend nach, wodurch eine elastische Welle 4 simuliert wird.

In nicht näher dargestellter Weise kann die Welle 4 verschiebbar bzw. verstellbar gelagert sein. Somit ist gegebenenfalls eine individuelle Einstellungsmöglichkeit gegeben. Die Vorspannung kann dabei in einfacher Weise durch den Lagerbock 30 eingestellt werden.

Im Ausführungsbeispiel ist, vorgesehen, dass die Welle 4 einen rechteckigen Querschnitt aufweist.

In nicht näher dargestellter Weise ist vorgesehen, dass der Adapter 2 und der Flugdatenspeicher 1 elektrische Kupplungselemente aufweisen, die in Verschlussstellung selbstständig miteinander kontaktieren. Die adapterseitigen elektrischen Kupplungselemente sind dabei im Bereich der Rückwand 18 angeordnet. Die elektrischen Kupplungselemente des Flugdatenspeichers 1 sind vorzugsweise in einer Rückwand 20, die an der Rückwand 18 des Adapters 2 in Verschlussstellung anliegt, angeordnet.

In nicht näher dargestellter Weise kann vorgesehen sein, dass der Bedienhebel 5 in Ruhestellung d. h. ohne Flugdatenspeicher 1) gegen ungewollte Bewegung gesichert ist. Dies kann beispielsweise durch eine in die Exzentereinrichtung eingreifende (Blatt-) Feder erfolgen.

Elektrisch und mechanisch ist der Flugdatenspeicher 1 als eigenständige Einheit ausgebildet, die über einen Bilddatenanschluss mit einer digitalen Kamera verbunden ist. Weiterhin ist ein Kontrolldaten-Eingang, ein Kontrolldaten-Ausgang und ein Versorgungsspannungs-Eingang, ein Versorgungsspannungs-Ausgang sowie ein serieller Anschluss zur RAID-Konfiguration vorhanden.

Erfindungsgemäß kann vorgesehen sein, dass der Flugdatenspeicher ein Speichermedium oder mehrere Speichermedien und/oder weitere Systembestandteile aufweist bzw. beinhaltet.

Fig. 10 zeigt beispielhaft eine Anordnung von zwei Speichermedien 22, z.B. Festplatten in einer Tragstruktur 21 die über vier Drahtseil-Schwingungsdämpfer 23 an der Innenseite des Gehäuses des Flugdatenschreibers 1 schwingungsgedämpft aufgehängt ist. Fig. 10 zeigt ebenfalls beispielhaft ein weiteres Systembestandteil 24, das an der Außenseite der Tragstruktur 21 angeordnet ist. Das weitere Systembestandteil 24 ist im Ausführungsbeispiel als Controller ausgebildet. Systembestandteile die nicht stoß- bzw. schwingungsempfindlich sind können auch direkt an dem Gehäuse des Flugdatenspeichers 1 angebracht sein.

Die schwingungsgedämpfte Anordnung der Speichermedien 22 ermöglicht es, dass relativ einfache und kostengünstige Standardspeichermedien, z.B. Standardfestplatten eingesetzt werden können. Von Vorteil ist außerdem, dass der Flugdatenspeicher 1 während des Transportes zu oder von dem Adapter 2 nicht in einem separaten stoßgesicherten Transportbehälter angeordnet werden muss. Der Flugdatenspeicher 1 kann aufgrund der schwingungsgedämpften Anordnung der Speichermedien 22 in einfacher Weise mittels seinem Griff 6 getragen bzw. transportiert werden.

## Patentansprüche

1. Vorrichtung zur Befestigung einer portablen elektronischen Einheit an einem Adapter, welcher elektronisch und/oder mechanisch mit einer Konstruktionseinheit, insbesondere einem Flugzeug, verbunden ist,
**dadurch gekennzeichnet, dass**
der Adapter (2) mit einer Verriegelungseinrichtung (3) versehen ist, die ein über eine Welle (4) gelagertes Bedienelement (5) aufweist, wobei die Welle (4) mit einer Exzentereinrichtung (12) versehen ist und wobei die Exzentereinrichtung (12) die in den Adapter (2) eingesetzte portable Einrichtung (1) durch eine Betätigung des Bedienelementes (5) über einen Totpunkt der Exzentereinrichtung (12) hinaus in eine Verschlussstellung schiebt.

2. Vorrichtung nach Anspruch 1,
**dadurch gekennzeichnet, dass**
der Adapter (2) und die portable Einheit (1) jeweils Kulissenelemente (7,11) aufweisen, die zum Einnehmen der Verschlussstellung zueinander verschiebbar und in Verschlussstellung miteinander verklemmbar bzw. verkeilbar sind.

3. Vorrichtung nach Anspruch 1 oder 2,
**dadurch gekennzeichnet, dass**
der Adapter (2) seitliche Führungen (8) aufweist, die sich von einer Bodenfläche (9) des Adapters (2) nach oben erstrecken und wenigstens einen unteren Bereich 10 der in den Adapter (2) eingesetzten portablen Einheit (1) seitlich umfassen.

4. Vorrichtung nach Anspruch 3,
**dadurch gekennzeichnet , dass**
die Kulissenelemente (7) des Adapters (2) an der Innenseite der seitlichen Führungen (8) angeordnet sind.

5. Vorrichtung nach Anspruch 2, 3 oder 4
**dadurch gekennzeichnet, dass**
die Kulissenelemente (11) der portablen Einheit (1) an deren Außenseite angeordnet sind.

6. Vorrichtung nach einem der Ansprüche 2 bis 5,
**dadurch gekennzeichnet, dass**
die zum gegenseitigen Verkeilen bzw. Verklemmen vorgesehenen Anlageflächen der Kulissenelemente (7,11) keilförmig ausgebildet sind.

7. Vorrichtung nach einem der Ansprüche 1 bis 6,
**dadurch gekennzeichnet, dass**
die Exzentereinrichtung (12) zwei Exzenterglieder (13) aufweist, die jeweils im Bereich eines Endes der Welle (4) angeordnet sind.

8. Vorrichtung nach Anspruch 7,
**dadurch gekennzeichnet, dass**
jedem Exzenterglied (13) eine horizontale Kontaktfläche (14) und eine vertikale Kontaktfläche (15) der portablen Einheit (1) zugeordnet ist.

9. Vorrichtung nach Anspruch 7 oder 8,
**dadurch gekennzeichnet, dass**
die Exzenterglieder (13) jeweils wenigstens zwei Auskragungen (16,17) aufweisen.

10. Vorrichtung nach Anspruch 7, 8 oder 9,
**dadurch gekennzeichnet, dass**
die Exzenterglieder (13) als exzentrisch auf der Welle (4) angeordnete Kurvenringe ausgebildet sind, die jeweils zwei radial überstehende Auskragungen (16,17) aufweisen.

11. Vorrichtung nach Anspruch 9 oder 10,
**dadurch gekennzeichnet, dass**
die Auskragungen (16,17) derart angeordnet bzw. ausgebildet sind, dass durch die Drehbewegung der Welle (4) ein zweistufiger Bewegungsablauf auf die portable Einheit (1) übertragbar ist.

12. Vorrichtung nach Anspruch 11,
**dadurch gekennzeichnet, dass**
in der ersten Stufe der Drehbewegung die jeweils in Drehrichtung der Welle (4) vorne liegenden Auskragungen (16) der Exzenterglieder (13) die jeweils zugeordneten vertikalen Kontaktflächen (15) der portablen Einheit (1) kontaktieren und die portable Einheit (1) in die Verschlussstellung schieben.

13. Vorrichtung nach Anspruch 11 oder 12,
**dadurch gekennzeichnet, dass**
in der zweiten Stufe der Drehbewegung die jeweils in Drehrichtung der Welle (4) hinten liegenden Auskragungen (17) der Exzenterglieder (13) die horizontalen Kontaktflächen (14) der portablen Einheit (1) kontaktieren und die portable Einheit (1) derart anheben, dass die portable Einheit (1) senkrecht zur Einschubrichtung derart verklemmt, dass die portable Einheit unterhalb einer vorgehenden Haltekraft in keiner Richtung verschieblich ist.

14. Vorrichtung nach Anspruch 6 und 13,
**dadurch gekennzeichnet, dass**
die keilförmig ausgebildeten Kulissenelemente (7,11) zueinander derart angeordnet sind, dass diese durch das Anheben der portablen Einheit (1) miteinander verklemmen bzw. verkeilen.

15. Vorrichtung nach einem der Ansprüche 1 bis 14,
**dadurch gekennzeichnet, dass**
die Welle (4) als elastische bzw. biegeweiche Welle ausgebildet ist.

16. Vorrichtung nach einem der Ansprüche 1 bis 14,
**dadurch gekennzeichnet, dass**
die Welle (4) auf wenigstens einem Federelement (19) angeordnet ist, welches die Welle (4) im wesentlichen vertikal in Richtung auf die horizontalen Kontaktflächen (14) vorspannt.

17. Vorrichtung nach Anspruch 16,
**dadurch gekennzeichnet, dass**
das Federelement als Tellerfeder (19) ausgebildet ist, auf der die Welle (4) ruht bzw. gelagert aufliegt.

18. Vorrichtung nach Anspruch 16 oder 17,
**dadurch gekennzeichnet, dass**
die Welle (4) als steife Welle ausgebildet ist.

19. Vorrichtung nach einem der Ansprüche 1 bis 18,
**dadurch gekennzeichnet, dass**
die Welle (4) verschiebbar bzw. verstellbar gelagert ist.

20. Vorrichtung nach einem der Ansprüche 1 bis 19,
**dadurch gekennzeichnet, dass**
die Welle (4) einen rechteckigen Querschnitt aufweist.

21. Vorrichtung nach einem der Ansprüche 1 bis 20,
**dadurch gekennzeichnet, dass**
der Adapter (2) und die portable Einheit (1) mit elektronischen Kupplungselementen versehen sind, die in Verschlussstellung miteinander kontaktieren.

22. Vorrichtung nach einem der Ansprüche 1 bis 21,
**dadurch gekennzeichnet, dass**
die portable elektronische Einheit (1) als Flugdatenspeicher ausgebildet ist.

23. Vorrichtung zur Befestigung einer portablen Speichereinrichtung in einem Flugzeug, wobei die Speichereinrichtung ein Gehäuse aufweist in dem wenigstens ein Speichermedium angeordnet ist,
**gekennzeichnet durch**
einen zur Aufnahme der Speichereinrichtung (1) geeigneten Adapter (2), wobei der Adapter (2) elektronisch und/oder mechanisch mit dem Flugzeug (25) verbunden ist.

24. Vorrichtung nach Anspruch 23,
**dadurch gekennzeichnet, dass**
der Adapter (2) und der Speichereinrichtung (1) mit elektronischen Kupplungselementen versehen sind, die in Verschlussstellung miteinander kontaktieren.

25. Vorrichtung nach Anspruch 23 oder 24',
**dadurch gekennzeichnet, dass**
die Speichereinrichtung (1) mehrere Speichermedien (22) und/oder weitere Systembestandteile (24) aufweist.

26. Vorrichtung nach Anspruch 23, 24 oder 25,
**dadurch gekennzeichnet, dass**
die Speichermedien (22) in dem Gehäuse der Speichereinrichtung (1) schwingungsgedämpft angeordnet bzw. aufgehängt ist.

27. Vorrichtung nach einem der Ansprüche 23 bis 26,
**dadurch gekennzeichnet, dass**
die Speichereinrichtung als Flugdatenspeicher 1 ausgebildet ist, auf den während eines Bildfluges des Flugzeuges (25) von einer digitalen Kamera anfallende Daten ablegbar sind.
